# EUROPÄISCHE PATENTSCHRIFT

(11) **EP 0 913 000 B1**
(45) Veröffentlichungstag und Bekanntmachung des Hinweises auf die Patenterteilung: **16.04.2008**
(21) Anmeldenummer: 98906848.1
(22) Anmeldetag: 27.01.1998
(51) Int. Cl.: H01L 29/739, H01L 29/10, H01L 29/06

(54) **DURCH FELDEFFEKT STEUERBARES HALBLEITERBAUELEMENT**
FIELD EFFECT CONTROLLABLE SEMICONDUCTOR COMPONENT
COMPOSANT A SEMICONDUCTEUR POUVANT ETRE COMMANDE PAR EFFET DE CHAMP

(30) Priorität: 25.02.1997 DE 19707513
(43) Veröffentlichungstag der Anmeldung: 06.05.1999
(73) Patentinhaber: Infineon Technologies AG, 81669 München (DE)
(72) Erfinder: PFIRSCH, Frank, D-81545 München (DE); WERNER, Wolfgang, D-81545 München (DE); HIRLER, Franz, D-84424 Isen (DE)
(74) Vertreter: Patentanwälte Westphal, Mussgnug & Partner
(86) Internationale Anmeldenummer: PCT/DE1998/000244
(87) Internationale Veröffentlichungsnummer: WO 1998/038681

(56) Entgegenhaltungen:
- EP-A- 0 615 292
- EP-A- 0 732 749
- EP-A- 0 735 591
- DE-A- 4 309 764
- US-A- 4 821 095
- PATENT ABSTRACTS OF JAPAN vol. 095, no. 006, 31.Juli 1995 -& JP 07 078978 A (TOYOTA CENTRAL RES & DEV LAB INC), 20.März 1995,
- PATENT ABSTRACTS OF JAPAN vol. 007, no. 021 (E-155), 27.Januar 1983 -& JP 57 180164 A (NIPPON DENKI KK), 6.November 1982,

## Beschreibung

Die Erfindung bezieht sich auf ein durch Feldeffekt steuerbares Halbleiterbauelement, bestehend aus einem Halbleiterkörper mit einer Innenzone vom ersten Leitungstyp, die an die obere Oberfläche des Halbleiterkörpers angrenzt, mit einer Anodenzone vom zweiten Leitungstyp, die an die untere Oberfläche des Halbleiterkörpers angrenzt, mit zumindest einer Basiszone vom zweiten Leitungstyp, die in die obere Oberfläche des Halbleiterkörpers eingebettet ist, mit zumindest einer Emitterzone vom ersten Leitungstyp, die in die Basiszone eingebettet ist, mit einer Emitterelektrode, die über der oberen Oberfläche des Halbleiterkörpers angeordnet ist und mit der Emitterzone leitend verbunden ist, mit einer Kollektorelektrode, die unter der unteren Oberfläche des Halbleiterkörpers angeordnet ist und mit der Anodenzone leitend verbunden ist, und mit einer Gateelektrode, die über der oberen Oberfläche des Halbleiterkörpers angeordnet ist und in einem Isolierabstand Teile der Basiszone und der Emitterzone überdeckt.

Ein Halbleiterbauelement der genannten Art ist als IGBT (Insulated Gate Bipolar Transistor) bekannt geworden und beispielsweise in der US 4,364,073 eingehend beschrieben. Alle bekannten IGBTs sind unabhängig von der Herstelltechnologie im wesentlichen ähnlich aufgebaut und zeigen ähnliches elektrisches Verhalten. Im Vorwärtsbetrieb können hohe Sperrspannungen blockiert und große Leistungen geschaltet werden. Im Rückwärtsbetrieb zeigen die IGBTS eine markante Diodenkennlinie, die durch eine mit der Gatespannung beeinflußbare Transistorkennlinie überlagert werden kann. Im Laststrompfad eines IGBT liegt eine Diode in Flußrichtung vor. Schaltet der MOS-Transistor ein, so fließt ein Majoritätsladungsträgerstrom über den MOS-Kanal durch die Basiszone und über den pn-Übergang zur Kollektorzone. Dies hat zur Folge, daß Minoritätsladungsträger in die Innenzone injiziert werden. Ein Teil der Minoritätsladungsträger fließt direkt über die Basiszone zur Emitterelektrode. Dieser Anteil des Minoritätsladungsträgerstromes erzeugt in der Basiszone einen Spannungsabfall.

Da die Basiszone als Senke für die Minoritätsträger wirkt, konnte die Kollektor-Emitter-Spannung im Durchlaßfall bei den eingangs genannten planaren IGBTS nicht deutlich verringert werden, ohne die Durchbruchspannung der Bauelemente herabzusetzen. Daher wurden IGBTS mit aus der DRAM-Technologie abgeleiteten Trench-Strukturen entwickelt. Der Unterschied zu den eingangs genannten planaren IGBTS liegt darin, daß in die Innenzone durch anisotrope Ätzung ein V-förmiger oder U-förmiger Graben eingebracht wird, in dem die Gateelektrode gegenüber der Innenzone isoliert angeordnet ist. Man erreicht dadurch sehr niedrige Flächenwiderstände und hohe Packungsdichten.

Andererseits ist aber diese nicht planare Anordnung wegen ihrer starken Abweichung von der relativ einfachen Planartechnologie nachteilig.

Aufgabe der vorliegenden Erfindung ist es daher, die eingangs genannten durch Feldeffekt steuerbaren Bauelemente in Planartechnologie so weiter zu bilden, daß die Parameter eines IGBTs mit Trenchstruktur erreicht werden, ohne daß die aufgezeigten Nachteile hingenommen werden müssen.

Erfindungsgemäß wird diese Aufgabe mit einem durch Feldeffekt steuerbaren Halbleiterbauelement der eingangs genannten Art gelöst, welches dadurch gekennzeichnet ist, daß die Basiszone in eine Abschirmungszone vom ersten Leitungstyp, die eine höhere Dotierungskonzentration aufweist als die sie umgebende Innenzone, eingebettet ist und daß im Bereich der Innenzone zumindest ein nicht angeschlossenes floatendes Gebiet mit hoher Dotierungskonzentration vom zweiten Leitungstyp angeordnet ist, dessen unterer Rand tiefer in der Innenzone liegt als der untere Rand der Abschirmungszone.

Durch das Einführen dieser Abschirmungszone wird in der Innenzone kurz vor der Basiszone ein zusätzlicher Widerstand eingebracht, der zu einer Konzentrationserhöhung an Minoritätsladungsträgern in der Innenzone führt. Dadurch wird der Spannungsabfall in der Innenzone deutlich verringert und es kommt demzufolge zu einer deutlichen Verringerung der Kollektor-Emitter-Spannung (V_{CESat}) im Durchlaßfall bei Nennstrom. Dadurch kann einerseits die statische Verlustleistung minimiert werden, andererseits lassen sich aber höhere Stromdichten erreichen, wodurch kleinere und damit kostengünstigere Halbleiterbauelemente für den gleichen Gesamtstrom verwendet werden können.

Ein IGBT mit einer Abschirmungszone ist aus der EP-A-0 615 292 bekannt.

Um die Sperrfestigkeit nicht zu beeinträchtigen, werden die von den Abschirmungszonen umgebenen Emitterbereiche durch die floatenden nicht angeschlossenen Gebiete abgeschirmt.

Die IGBTS weisen üblicherweise eine Vielzahl von Basiszonen, Emitterzonen und Abschirmungszonen auf, die translationsperiodisch angeordnet sind und durch Zwischenzellenzonen räumlich getrennt sind. Die Emitterzonen sind dabei parallel geschaltet. Diese Zellenstrukturen können streifenförmig, sechseckig, dreieckig, rund oder viereckig sein.

In einer Ausführungsform der vorliegenden Erfindung ist das floatende Gebiet unterhalb der Abschirmungszone und oberhalb der Anodenzone angeordnet. Es ist jedoch auch denkbar, daß das floatende Gebiet räumlich getrennt neben der Abschirmungszone in die obere Oberfläche des Halbleiterkörpers eingebettet ist, so daß bei einem zellenartig aufgebauten IGBT die floatende Gebiete in den Zwischenzellenzonen liegen.

Das aufgrund des Konzentrationsgefälles zwischen der Abschirmungszone und der Basiszone entstehende Driftfeld bewirkt, daß die Innenzone nicht mehr als Senke für die Minoritätsladungsträger wirkt, was im eingeschalteten Zustand des IGBTs eine entsprechende Anhebung der Minoritätsladungsträger bewirkt.

Typischerweise ist die Dotierungskonzentration in der Abschirmungszone deutlich höher als in der Innenzone. Als besonders geeignet haben sich Dotierungskonzentrationen von 10¹⁷/cm³ in der Abschirmungszone und von 10¹⁴/cm³ in der Innenzone erwiesen, da dadurch die Abschirmungszone deutlich höher dotiert ist als die Innenzone und so ein ausreichend hohes Konzentrationsgefälle zwischen diesen beiden Zonen entsteht, welches ein Driftfeld bewirkt, so daß die Innenzone nicht mehr als Senke für die Minoritätsladungsträger wirkt.

Die Erfindung ist in der Zeichnung beispielsweise veranschaulicht und im folgenden im einzelnen anhand der Zeichnung beschrieben. Es zeigen:
- Figur 1: einen Teilschnitt durch einen erfindungsgemäßen IGBT,
- Figur 2: einen Teilschnitt durch einen alternativen erfindungsgemäßen IGBT und
- Figur 3: einen Teilschnitt durch einen weiteren alternativen erfindungsgemäßen IGBT.

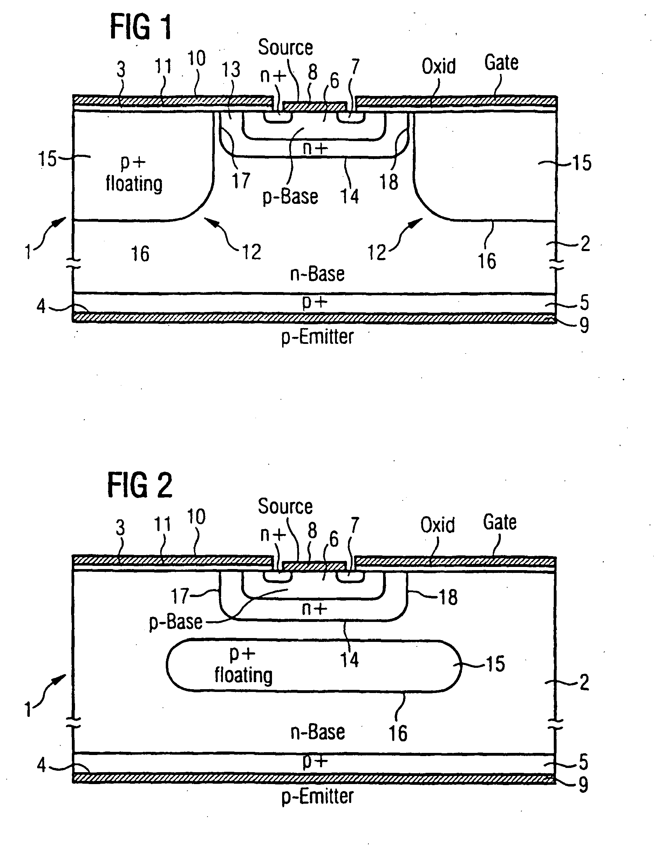

Die Figuren 1 bis 3 zeigen die Erfindung anhand eines n-Kanal-IGBTS. Die Erfindung kann selbstverständlich auch an p-Kanal-IGBTS umgesetzt werden. In den Figuren 1 bis 3 ist der Halbleiterkörper des Halbleiterbauelements mit 1 bezeichnet. Er hat eine obere Oberfläche 3 und eine untere Oberfläche 4. Er weist eine n⁻-dotierte Innenzone 2 auf, die an die obere Oberfläche 3 des Halbleiterkörpers 1 angrenzt. In die obere Oberfläche 3 ist eine p-dotierte Basiszone 6 eingebettet. In die Basiszone 6 sind zwei n⁺-dotierte Emitterzonen 7 eingebettet. Die Basiszonen 6 und die Emitterzonen 7 sind von Emitterelektroden 8 kontaktiert, die aus Metall, beispielsweise Aluminium, bestehen.

An die untere Oberfläche 4 der Innenzone 2 grenzt eine p⁺-dotierte Anodenzone 5 an. Diese ist über eine Metallisierung mit einer Kollektorelektrode 9 verbunden. Links und rechts neben der Basiszone 6 befinden sich Zwischenzellenzonen 12, die translationsperiodisch angeordnete Basiszonen voneinander räumlich trennen.

Isoliert durch ein Gateoxid 11 über der oberen Oberfläche 3 ist eine Gateelektrode 10 angeordnet. Die Gateelektrode 10 kann aus hochdotiertem Polysilizium bzw. aus Metall bestehen.

In der Figur 1 ist die Basiszone 6 in eine Abschirmungszone 13 eingebettet, welche stark n⁺-dotiert ist. Die Abschirmungszone 13 weist eine deutlich höhere Dotierungskonzentration auf als die sie umgebende Innenzone 2. Die Abschirmungszone 13 weist einen linken lateralen Rand 17 und einen rechten lateralen Rand 18 auf. Neben diesen lateralen Rändern befinden sich in räumlichem Abstand jeweils ein nicht angeschlossenes, floatendes Gebiet 15, welches stark p⁺-dotiert ist. Der untere Rand 16 dieser floatenden Gebiete 15 liegt dabei tief in der Innenzone 2. Insbesondere ist der untere Rand 16 der floatenden Gebiete 15 tiefer in der Innenzone angeordnet, als der untere Rand 14 der Abschirmungszone 13.

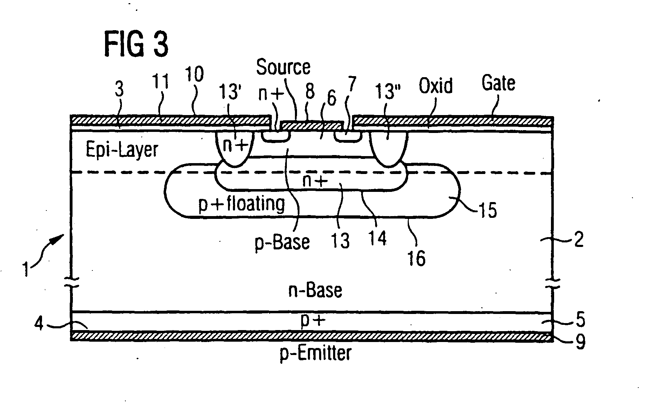

Figur 2 zeigt eine alternative Ausführungsform der vorliegenden Erfindung, bei der das floatende Gebiet 15 nicht lateral neben der Abschirmungszone 13 angeordnet ist, sondern sich unterhalb der Abschirmungszone 13 und oberhalb der Anodenzone 5 befindet. Das floatende Gebiet 15 ist hier in räumlichem Abstand zum unteren Rand der Abschirmungszone 14 angeordnet, wohingegen in der Figur 3 eine Ausführungsform gezeigt ist, bei der die Abschirmungszone 13 in das floatende Gebiet 15 eingebettet ist.

In allen drei gezeigten Ausführungsbeispielen ist die Dotierungskonzentration in der Abschirmungszone 13 wesentlich größer als in der Innenzone 2. Die Dotierungskonzentration in der Abschirmungszone 13 weist in allen drei gezeigten Ausführungsbeispielen einen Wert von ca. 10¹⁷/cm³ auf, wohingegen die Dotierungskonzentration in der Innenzone einen Wert von ca. 10¹⁴/cm³ aufweist.

Anhand der Figur 3 wird im folgenden beschrieben, wie die erfindungsgemäße Struktur hergestellt werden kann. In ein ndotiertes Substrat wird ein p-Dotierungsmittel, beispielsweise Bor, implantiert. Danach wird das Dotierungsmittel durch einen anschließenden Temperschritt "eingetrieben" oder diffundiert. In diese eingetriebene p⁺-dotierte Schicht, die als floatendes Gebiet 15 dient, wird daraufhin ein stark dotiertes n-leitendes Gebiet 13 eingetrieben. Dieses stark n-leitende Gebiet dient als Abschirmungszone 13. Auf diese Schicht wird dann epitaktisch wiederum eine schwach n-leitende Schicht abgeschieden, die den Halbleiterkörper nach oben hin abschließt. Auf die obere Oberfläche 3 dieser Schicht wird daraufhin die Basiszone 5 eingebettet und neben die Basiszone 5 werden über eine weitere Implantation an den lateralen Rändern der Basiszone stark n-leitende Zonen 13', 13'' implantiert. Diese stark n-dotierten Zonen 13', 13'' werden wiederum eingetrieben und zwar derart, daß sie mit der darunterliegenden stark n-Zone in Kontakt treten. Letztendlich bilden dann diese Gebiete die Umgebung der Basiszone. Daraufhin wird der so hergestellte Halbleiterkörper oben weiter prozessiert, d.h. es werden die Emitterzonen, die Emitterelektrode eventuell Kurzschlußbereiche sowie die Gateelektrode gebildet.

Nachfolgend wird die Funktionsweise der in den Figuren 1 bis 3 gezeigten Strukturen näher erläutert.

Durch die Abschirmungszone 13 wird in der Innenzone 2 ein zusätzlicher Widerstand für die Minoritätsladungsträger eingeführt. Dieser zusätzliche Widerstand bewirkt eine starke Herabsetzung der Kollektor-Emitter-Spannung im Durchlaßfall bei Nennstrom, d.h. V_{CESat} wird stark herabgesetzt. Damit kann einerseits die statische Verlustleistung minimiert werden, andererseits lassen sich höhere Stromdichten erreichen, wodurch kleinere und damit kostengünstigere Halbleiterbauelemente für den gleichen Gesamtstrom bereitgestellt werden können.

Durch die Einführung dieser Abschirmungszone 13 wird eine Struktur bereitgestellt, die zu einer erheblichen Anhebung der Minoritätsladungsträgerdichte an der Katodenseite des IGBTs, d.h. unterhalb der Basiszone 6 führt. Das aufgrund des Konzentrationsgefälles zwischen der Abschirmungszone 13 und der Innenzone 2 entstehende Driftfeld bewirkt, daß die Basiszone 6 nicht mehr als Senke für die Minoritätsladungsträger wirkt, was im eingeschalteten Zustand des IGBTs eine entsprechende Anhebung der Minoritätsladungsträger zur Folge hat. Damit die Durchbruchspannung des IGBTs durch die Einführung der Abschirmungszone 13 nicht reduziert wird, werden nicht angeschlossene floatende Gebiete 15 vom entgegengesetzten Leitungstyp eingeführt, die entweder unterhalb der Abschirmungszone 13 und oberhalb der Anodenzone 5 angeordnet sind oder neben den Basiszonen 6 in den Zwischenzellenzonen 12 liegen. Wesentlich ist dabei, daß die nicht angeschlossenen floatenden Gebiete 15 vom entgegengesetzten Leitungstyp eine Eindringtiefe aufweisen, die deutlich größer ist als die Eindringtiefe der Abschirmungszone in die Innenzone. Die nicht angeschlossenen floatenden Gebiete vom bezüglich der Abschirmungszone 13 entgegengesetzten Leitungstyp haben den Zweck, daß die Bereiche unmittelbar an der Katodenseite, d.h. unmittelbar unter der Basiszone 6 abgeschirmt werden, d.h. der Verlauf der Äquipotentiallinien nicht bis an die Unterkante der Basiszonen 6 reicht. Dadurch wird neben einem sehr kleinen V_{CESat} eine hohe Sperrfestigkeit erreicht.

## Patentansprüche

1. Durch Feldeffekt steuerbares Halbleiterbauelement bestehend aus einem Halbleiterkörper (1)
a) mit einer Innenzone (2) vom ersten Leitungstyp, die an die obere Oberfläche (3) des Halbleiterkörpers (1) angrenzt,
b) mit einer Anodenzone (5) vom zweiten Leitungstyp, die an die untere Oberfläche (4) des Halbleiterkörpers (1) angrenzt,
c) mit zumindest einer Basiszone (6) vom zweiten Leitungstyp, die in die obere Oberfläche (3) des Halbleiterkörpers (1) eingebettet ist,
d) mit zumindest einer Emitterzone (7) vom ersten Leitungstyp, die in die Basiszone (6) eingebettet ist,
e) mit einer Emitterelektrode (8), die über der oberen Oberfläche (3) des Halbleiterkörpers (1) angeordnet ist und mit der Emitterzone (7) leitend verbunden ist,
f) mit einer Kollektorelektrode (9), die unter der unteren Oberfläche (4) des Halbleiterkörpers (1) angeordnet ist und mit der Anodenzone (5) leitend verbunden ist, und
g) mit einer Gateelektrode (10), die über der oberen Oberfläche (3) des Halbleiterkörpers (1) angeordnet ist und in einem Isolierabstand Teile der Basiszone (6) und der Emitterzone (7) überdeckt,
**dadurch gekennzeichnet, daß**
h) die Basiszone (6) in eine Abschirmungszone (13) vom ersten Leitungstyp, die eine höhere Dotierungskonzentration aufweist als die sie umgebende Innenzone (2), eingebettet ist, und
i) im Bereich der Innenzone (2) zumindest ein nicht angeschlossenes floatendes Gebiet (15) hoher Leitfähigkeit vom zweiten Leitungstyp vorgesehen ist, dessen unterer Rand (16) tiefer in der Innenzone (2) liegt als der untere Rand (14) der Abschirmungszone (13).

2. Durch Feldeffekt steuerbares Halbleiterbauelement nach Anspruch 1,
**dadurch gekennzeichnet, daß** in dem Halbleiterkörper (1) eine Vielzahl von Basiszonen (6), Emitterzonen (7) und Abschirmungszonen (13) translationsperiodisch angeordnet sind und durch Zwischenzellenzonen (12) räumlich getrennt sind.

3. Durch Feldeffekt steuerbares Halbleiterbauelement nach Anspruch 1 oder 2,
**dadurch gekennzeichnet, daß** das floatende Gebiet (15) unterhalb der Abschirmungszone (13) und oberhalb der Anodenzone (5) angeordnet ist.

4. Durch Feldeffekt steuerbares Halbleiterbauelement nach Anspruch 1 oder 2,
**dadurch gekennzeichnet, daß** das floatende Gebiet (15) räumlich getrennt neben der Abschirmungszone (13) in die obere Oberfläche (3) des Halbleiterkörpers (1) eingebettet ist.

5. Durch Feldeffekt steuerbares Halbleiterbauelement nach Anspruch 3 oder 4,
**dadurch gekennzeichnet, daß** die Dotierungskonzentration der Abschirmungszone (13) ca. drei Zehnerpotenzen größer ist als die Dotierungskonzentration der Innenzone (2).

## Claims

1. Field effect-controllable semiconductor component comprising a semiconductor body (1)
a) having an inner zone (2) of the first conduction type, which adjoins the upper surface (3) of the semiconductor body (1).
b) having an anode zone (5) of the second conduction type, which adjoins the lower surface (4) of the semiconductor body (1),
c) having at least one base zone (6) of the second conduction type, which is embedded in the upper surface (3) of the semiconductor body (1),
d) having at least one emitter zone (7) of the first conduction type, which is embedded in the base zone (6),
e) having an emitter electrode (8), which is arranged above the upper surface (3) of the semiconductor body (1) and is conductively connected to the emitter zone (7),
f) having a collector electrode (9), which is arranged below the lower surface (4) of the semiconductor body (1) and is conductively connected to the anode zone (5), and
g) having a gate electrode (10), which is arranged above the upper surface (3) of the semiconductor body (1) and, with an insulating clearance, covers parts of the base zone (6) and of the emitter zone (7),
**characterized in that**
h) the base zone (6) is embedded in a shielding zone (13) of the first conduction type, which has a higher doping concentration than the inner zone (2) surrounding it, and
i) at least one nonconnected, floating region (15) of high conductivity of the second conduction type is provided in the region of the inner zone (2), the lower edge (16) of which region (15) is deeper in the inner zone (2) than the lower edge (14) of the shielding zone (13).

2. Field effect-controllable semiconductor component according to Claim 1,
**characterized in that** a multiplicity of base zones (6), emitter zones (7) and shielding zones (13) are arranged translationally periodically, and are spatially separated by intercell zones (12), in the semiconductor body (1).

3. Field effect-controllable semiconductor component according to Claim 1 or 2,
**characterized in that** the floating region (15) is arranged below the shielding zone (13) and above the anode zone (5).

4. Field effect-controllable semiconductor component according to Claim 1 or 2, **characterized in that** the floating region (15) is embedded, spatially separated next to the shielding zone (13), in the upper surface (3) of the semiconductor body (1).

5. Field effect-controllable semiconductor component according to Claim 3 or 4,
**characterized in that** the doping concentration of the shielding zone (13) is approximately three powers of ten greater than the doping concentration of the inner zone (2).

## Revendications

1. Composant à semi-conducteur pouvant être commandé par effet de champ et constitué d'un corps (1) semi-conducteur
a) ayant une zone (2) intérieure du premier type de conductivité, qui est voisine de la surface (3) supérieure du corps (1) semi-conducteur,
b) ayant une zone (5) d'anode du deuxième type de conductivité, qui est voisine de la surface (4) inférieure du corps (1) semi-conducteur,
c) ayant au moins une zone (6) de base du deuxième type de conductivité, qui est incorporée dans la surface (3) supérieure du corps (1) semi-conducteur,
d) ayant au moins une zone (7) d'émetteur du premier type de conductivité, qui est incorporée dans la zone (6) de base,
e) ayant une électrode (8) d'émetteur, qui est disposée au-dessus de la surface (3) supérieure du corps (1) semi-conducteur et qui est reliée d'une manière conductrice à la zone (7) d'émetteur,
f) ayant une électrode (9) de collecteur, qui est disposée sous la surface (4) inférieure du corps (1) semi-conducteur et qui est reliée de manière conductrice à la zone (5) d'anode, et
g) ayant une électrode (10) de grille, qui est disposée au-dessus de la surface (3) supérieure du corps (1) semi-conducteur et qui recouvre à une distance isolante les parties de la zone (6) de base et de la zone (7) d'émetteur,
**caractérisé en ce que**
h) la zone (6) de base est incorporée dans une zone (13) de protection du premier type de conductivité qui a une concentration de dopage plus grande que la zone (2) intérieure qui l'entoure, et
i) il est prévu, dans la région de la zone (2) intérieure, au moins un domaine (15) flottant non raccordé de plus grande conductivité du deuxième type de conductivité et dont le bord (16) inférieur va plus profondément dans la zone (2) intérieure que le bord (14) inférieur de la zone (13) de protection.

2. Composant à semi-conducteur pouvant être commandé par effet de champ suivant la revendication 1,
**caractérisé en ce que**, dans le corps (1) semi-conducteur, sont disposées, suivant une périodicité de translation, une pluralité de zones (6) de base, de zones (7) d'émetteur et de zones (13) de protection, qui sont séparées dans l'espace par des zones (12) de cellules intermédiaires.

3. Composant à semi-conducteur pouvant être commandé par effet de champ suivant la revendication 1 ou 2,
**caractérisé en ce que** le domaine (15) flottant est disposé en dessous de la zone (13) de protection et au-dessus de la zone (5) d'anode.

4. Composant à semi-conducteur pouvant être commandé par effet de champ suivant la revendication 1 ou 2,
**caractérisé en ce que** le domaine (15) flottant est incorporé d'une manière séparée dans l'espace à côté de la zone (13) de protection, dans la zone (3) supérieure du corps (1) semi-conducteur.

5. Composant à semi-conducteur pouvant être commandé par effet de champ suivant la revendication 3 ou 4,
**caractérisé en ce que** la concentration de dopage de la zone (13) de protection est plus grande d'environ trois puissances de dix que la concentration de dopage de la zone (2) intérieure.
